# EUROPÄISCHE PATENTSCHRIFT

(11) **EP 0 963 839 B1**
(45) Veröffentlichungstag und Bekanntmachung des Hinweises auf die Patenterteilung: **29.09.2004**
(21) Anmeldenummer: 99109362.6
(22) Anmeldetag: 01.06.1999
(51) Int. Cl.: B41C 1/10

(54) **Druckmaschine und Druckverfahren**
Printing machine and printing process
Machine et méthode pour l'impression

(30) Priorität: 12.06.1998 DE 19826377
(43) Veröffentlichungstag der Anmeldung: 15.12.1999
(60) Teilanmeldung: 04005584.0
(73) Patentinhaber: Heidelberger Druckmaschinen Aktiengesellschaft, 69115 Heidelberg (DE)
(72) Erfinder: d'Heureuse, Walter, 68526 Ladenburg (DE); Schmitt-Lewen, Martin, 69245 Bammental (DE); Kipphan, Helmut, Prof. Dr., 68723 Schwetzingen (DE)
(74) Vertreter: Pudimat, Roland

(56) Entgegenhaltungen:
- EP-A- 0 903 223
- EP-A- 0 911 154
- EP-A- 0 911 155
- FR-A- 1 572 007
- FR-A- 1 601 856
- PATENT ABSTRACTS OF JAPAN vol. 098, no. 014, 31. Dezember 1998 (1998-12-31) & JP 10 250027 A (FUJITSU LTD), 22. September 1998 (1998-09-22)
- WANG R ET AL: "PHOTOGENERATION OF HIGHLY AMPHIPHILIC TIO2 SURFACES" ADVANCED MATERIALS, Bd. 10, Nr. 2, 22. Januar 1998 (1998-01-22), Seiten 135-138, XP000727857 ISSN: 0935-9648

## Beschreibung

Die Erfindung betrifft eine Druckmaschine und zugehörige Druckverfahren. Beim Offsetdruck werden immer größere Teile der Arbeiten zur Herstellung der Druckform, der sogenannten Druckvorstufe, mit Hilfe von elektronischer Datenverarbeitung durchgeführt. Bei der sogenannten Computer-to-plate-Technik laufen sämtliche Arbeiten von der Erstellung des Seitenlayouts bis zur digital angesteuerten Bebilderung der Druckplatte im Computer ab. Die Bebilderung der Druckplatten findet getrennt in einer speziellen Belichtungseinheit statt. Bei der sogenannten Computer-to-press/Direct Imaging-Technik, wie sie die Heidelberger Druckmaschinen AG erstmalig in der GTO-DI angewendet hat, ist die Belichtungseinheit in die Druckmaschine verlagert. Die Platten werden direkt in der Druckmaschine auf dem Zylinder belichtet.

Hinsichtlich Digitaldruck noch weitergehende Techniken, auch Computer-toprint und Computer-to-paper genannt, bestehen darin, digitalisierte Daten aus einem Computer ohne Druckform mit festem Bild über einen Zwischenträger (z.B. Fotoleiter) oder ohne jede materielle Zwischenstufe auf Papier oder andere Bedruckstoffe zu übertragen. Entsprechende Drucktechniken sind z.B. Elektrofotografie, Thermotransferdruck oder Tintenstrahldruck und erlauben es, das Motiv während des laufenden Drucks zu wechseln, z.B. mit jeder Umdrehung eines Formzylinders ein neues Druckbild zu erzeugen. Hierbei entfällt die Herstellung einer Druckform, da jedes einzelne Druckbild neu geschrieben wird. Damit verzichtet man jedoch auf den Vorteil konventioneller Verfahren wie z.B. Offsetdruck, von einer konstanten Druckform mit hoher Produktivität drucken zu können und über die Auflage eine sehr hohe Qualität zu gewährleisten.

Aus Dokument EP-A-0911154, welches Stand der Technik nach Art. 54(3)-(4) EPÜ bildet, ist bereits eine Vorrichtung sowie ein Verfahren zum Bebildern wiederbeschreibbarer Druckplatten bekannt. Dabei wird eine Druckplatte zunächst durch vollflächige UV-Bestrahlung in einen hydrophilen Zustand und anschließend lokal in den Bildbereichen mit IR-Bestrahlung in einen lipophilen Zustand versetzt. In einem darauffolgenden Schritt wird in konventioneller Weise Druckfarbe und Feuchtmittel auf die zuvor bebilderte Oberfläche der Druckplatte aufgebracht.

Auch aus Dokument EP-A-0911155, welches ebenfalls Stand der Technik nach Art. 54(3)-(4) EPÜ bildet, ist bereits eine Vorrichtung sowie ein Verfahren zum Bebildern wiederbeschreibbarer Druckplatten bekannt. Dabei wird eine Druckplatte zunächst durch Wärmebehandlung, z. B. durch IR-Bestrahlung, vollflächig in einen lipophilen Zustand und anschließend lokal in den Nicht-Bildbereichen mit UV-Bestrahlung in einen hydrophilen Zustand versetzt. In einem darauffolgenden Schritt wird in konventioneller Weise Druckfarbe und Feuchtmittel auf die zuvor bebilderte Oberfläche der Druckplatte aufgebracht.

Der Erfindung liegt die Aufgabe zugrunde, eine Druckmaschine und korrespondierende Druckverfahren zu schaffen, mit denen es möglich ist, sowohl kontinuierlich von einem Master zu drucken, wie es beim Offsetdruck geschieht, als auch das Motiv während des laufenden Drucks zu ändern, wie es z.B. bei Elektrofotografie möglich ist.

Ausgehend von einer Druckmaschine für die Computer-to-press/Direct Imaging-Technik, die eine Druckform, eine optische Bebilderungseinheit zur Direktbebilderung der Druckform, ein Farbwerk zur Einfärbung der Druckform und eine Reinigungseinrichtung zur Reinigung der Oberfläche der Druckform enthält, wobei die Oberfläche der Druckform aus einem Material besteht, dessen Benetzungseigenschaften reversibel zwischen einem Zustand mit einem sehr kleinen und einem Zustand mit einem relativ großen Randwinkel veränderlich sind, und wobei der Zustand mit einem sehr kleinen Randwinkel durch Einwirkung von Licht erreicht wird, dessen Wellenlänge kürzer als eine materialspezifische Wellenlänge ist, wird diese Aufgabe erfindungsgemäß dadurch gelöst, daß eine Feuchtluftstation zur Bildung einer molekularen Wasserschicht auf der Druckform vorgesehen ist.

Der Randwinkel ist definiert als der Winkel, den die Oberfläche einer an die Druckformoberfläche angrenzenden Flüssigkeit mit der Druckformoberfläche bildet, und ist ein Maß für die Grenzflächenspannung zwischen der Druckformoberfläche und der Flüssigkeit.

Ein Material mit den genannten Eigenschaften existiert z.B. in Form von TiO₂, vgl. die Zeitschrift Nature, Vol. 388, 31. Juli 1997, S. 431. TiO₂-Oberflächen werden unter ultravioletter Strahlung amphiphil, d.h. sowohl hydrophil als auch oleophil. Insbesondere ändert sich z.B. der Randwinkel von Wasser an der Oberfläche von normalerweise 72° auf im wesentlichen 0° bei Belichtung; die veränderte Oberflächeneigenschaft ist reversibel. Mit diesem oder einem Material mit ähnlichen Eigenschaften wird die Druckform beschichtet, die häufig ein Formzylinder ist, aber auch eine Druckplatte oder ein Band sein kann.

Die Anordnung und Funktion der Bestandteile einer solchen Druckmaschine richtet sich danach, welches von mehreren alternativen Druckverfahren verwendet wird, die in den Patentansprüchen 1, 5 und 7 angegeben sind.

Zur Durchführung des ersten Verfahrens gemäß Patentanspruch 1 wird der Bebilderungseinheit eine Flächenbelichtungseinheit vorgeschaltet, um die Druckform gleichmäßig flächig mit Licht zu bestrahlen, dessen Wellenlänge kürzer als die materialspezifische Wellenlänge ist. Anschließend bildet sich eine zusammenhängende molekulare Wasserschicht auf der Druckform, die keine Farbannahme zuläßt. Die Bebilderungseinheit sendet Licht mit einer größeren Wellenlänge als die materialspezifische Wellenlänge aus, dessen Intensität und Einwirkungsdauer so groß ist, daß die molekulare Wasserschicht auf der Druckform in Bildbereichen abgetragen wird. Die Bildbereiche nehmen die Druckfarbe an, die anschließend auf den Bedruckstoff übertragen wird. Die Vorgänge der Einfärbung und Übertragung können ohne Neubebilderung nach Belieben wiederholt werden, da das Druckbild selbsterhaltend ist. Für einen Wechsel des Druckmotivs wird die Druckform gereinigt, und die Vorgänge können von neuem beginnen.

Das Wasser zur Bildung der molekularen Wasserschicht auf der Druckform kann entweder aus der Umgebungsluft aufgenommen werden, oder die Bildung der molekularen Wasserschicht wird aktiv unterstützt, indem die Druckform mit Wasserdampf oder feuchter Luft beaufschlagt wird.

Die molekulare Wasserschicht, die nach Belichtung mit Licht entsteht, dessen Wellenlänge kürzer als die materialspezifische Wellenlänge ist und das im Falle von TiO₂ ultraviolettes Licht ist, wird in der Praxis nicht absolut gleichmäßig sein. Unter einer molekularen Wasserschicht wird hier eine regelmäßige oder unregelmäßige Verteilung von Wassermolekülen mit einer durchschnittlichen Dicke zwischen einer Moleküllage und mehreren Moleküllagen auf der Oberfläche verstanden. So eine Wasserschicht ist in jedem Falle wesentlich dünner als ein Wasserfilm, wie er im konventionellen Offsetdruck verwendet wird.

Die besonderen Eigenschaften einer solchen Wasserschicht bestehen im wesentlichen darin, daß die molekulare Wasserschicht tendenziell kein weiteres Wasser aufnimmt, im Gegensatz zu einem makroskopischen Wasserfilm, wie er z.B. von einem Feuchtwerk einer Druckmaschine auf eine Druckform aufgebracht wird. Außerdem ist die molekulare Wasserschicht mehr oder weniger oleophob, d.h. im Falle einer ölbasierenden Farbe farbabstoßend.

Die Bebilderungseinheit kann z.B. ein steuerbarer Infrarotlaser mit einer Strahlablenkeinheit oder eine LED-Zeile mit Infrarot-Leuchtdioden sein, der bzw. die die Druckform bildpunktweise bzw. zeilenweise beschreibt. Derartige Bebilderungseinheiten gibt es z.B. für elektrofotographische Drucker.

Bei dem zweiten Verfahren gemäß Patentanspruch 7 ist es nicht notwending, die Wasserschicht partiell abzutragen. Vielmehr wird eine Bebilderungseinheit verwendet, die die Oberfläche, die sich zuerst in dem Zustand mit relativ großem Randwinkel befindet, in den Bildbereichen mit Licht bestrahlt, dessen Wellenlänge kürzer als materialspezifische Wellenlänge ist. An den belichteten Stellen lagert sich Wasser an, und die unbelichteten Stellen nehmen Farbe an. Zur Durchführung des zweiten Verfahrens würde man im Falle einer TiO₂-Oberfläche eine Ultraviolett-Bebilderungseinheit benötigen. Laser-Bebilderungseinheiten für ultraviolettes Licht sind sehr kostspielig, und entsprechende LED-Bebilderungseinheiten stehen zur Zeit noch nicht serienmäßig zur Verfügung. Jedoch kann man z.B. eine herkömmliche UV-Quelle verwenden, die einen gebündelten Strahl erzeugt, der wie ein Laserstrahl abgelenkt und moduliert wird, um ein Bild auf die Druckform zu schreiben. Weitere Möglichkeiten sind, die Druckform durch eine Maske hindurch mit ultraviolettem Licht zu bestrahlen oder ein Array von schaltbaren Spiegeln zu verwenden.

Bei dem zweiten Verfahren wird ein Negativbild des Druckbildes auf der Druckform hergestellt.

Bei dem zweiten Verfahren ist es notwendig, daß die molekulare Wasserschicht die Druckfarbe hinreichend abweist, was unter anderem von der Dicke der molekularen Wasserschicht und der Art der Druckfarbe abhängen kann.

Abhängig von der speziellen Beschaffenheit der Oberfläche der Druckform und von dem verwendeten Druckverfahren kann die Druckfarbe möglicherweise eine konventionelle oder eine geeignet modifizierte Offsetfarbe sein.

Die heutigen Offsetfarben für wasserlosen Offsetdruck enthalten Silikonöl. Beim Farbauftrag auf die Silikonoberfläche der Druckform bildet sich ein feiner Silikonölfilm, der die Farbannahme in den druckfreien Bereichen verhindert. In Analogie dazu kann eine wasserbasierende Farbe entwickelt werden, die im Zusammenspiel mit der molekularen Wasserschicht auf der Druckform ebenfalls eine abstoßende Wirkung zeigt. Daher sind die für die Erfindung in Betracht kommenden Druckfarben nicht auf ölbasierende Farben beschränkt.

Wie erwähnt, ist bei der Druckmaschine und den Druckverfahren der Erfindung das Druckbild wegen der besonderen Eigenschaften der Oberfläche der Druckform selbsterhaltend. Daher muß das Druckbild nicht für jeden einzelnen Druckvorgang neu aufgebracht werden. Nachdem die gewünschte Anzahl Drucke hergestellt worden ist, kann die Zylinderoberfläche mit einem geeigneten Reinigungsmittel gereinigt werden. Zur Durchführung des Verfahrens zwei kann ein Reinigungsmittel von Vorteil sein, das auf chemischem und/oder physikalischem Wege den Zustand mit relativ großem Randwinkel wiederherstellt. Bei dem ersten Verfahren ist dies nicht notwendig, da die Oberfläche durch die Flächenbelichtungseinheit vollständig amphiphil gemacht wird, bevor ein neues Druckbild geschrieben wird.

Die erwähnten TiO₂-Oberflächen wurden im Hinblick darauf entwickelt, das Beschlagen von Fensterscheiben zu verhindern sowie eine Selbstreinigung von Oberflächen in Außenbereichen zu erreichen. Für diese Anwendungen sind lange Standzeiten von Vorteil. Für die Erfindung ist es jedoch von Vorteil, wenn das Druckbild möglichst schnell geändert werden kann, bis hin zu dem Fall, daß z.B. bei jeder Umdrehung eines Formzylinders ein neues Druckbild geschrieben werden kann.

Wenn es daher im Fall des Verfahrens zwei nicht möglich oder mit zu hohem Aufwand verbunden ist, die amphiphile Eigenschaft der Druckformoberfläche z.B. mit Hilfe der Reinigungseinrichtung gezielt zurückzubilden, sollte die Standzeit eher kurz sein, damit die amphiphile Eigenschaft der Druckformoberfläche schnell von selbst abklingen kann und sofort ein neues Druckbild geschrieben werden kann. Bei einer TiO₂-Oberfläche läßt sich dies möglicherweise durch Änderungen der chemischen Zusammensetzung oder durch physikalische Strukturänderungen erreichen, oder man findet weitere Stoffe, die ähnliche oder für die Anwendung bei Druckmaschinen noch günstigere Eigenschaften haben.

Falls die Standzeit der amphiphilen Eigenschaft der Druckformoberfläche bis auf ungefähr 0,1 bis 1 Sekunde herabgesetzt werden kann, kann z.B. bei jeder Umdrehung eines Formzylinders ein neues Druckbild geschrieben werden. Da das Druckbild in diesem Fall nur eine sehr kurze Zeit erhalten bleibt, müßte es nicht nur im Falle von Einzelmotivdruck, sondern auch im Falle von Auflagendruck fortlaufend erneuert werden. In Übereinstimmung mit der Erfindung sind die Vorteile des Offsetdrucks weiter vorhanden.

Die optimale Standzeit hängt vom jeweiligen Anwendungszweck der Druckmaschine ab. Je nachdem, in welchem Umfang Auflagendruck und in welchem Umfang Einzelmotivdruck gewünscht ist, wird man möglicherweise einen Kompromiß eingehen.

Die gewünschten Eigenschaften der Druckformoberfläche lassen sich durch geeignete Wahl der Kristallform des Oberflächenmaterials und gegebenenfalls durch Zugabe von weiteren Materialen (z.B. Dotierung mit geeigneten Fremdatomen) bei der Herstellung erzielen bzw. für den vorliegenden Anwendungszweck optimieren. Als Basismaterial kommen auch andere Materialien als Titanoxid in Betracht, z.B. Hafniumoxid oder Oxide von anderen Elementen der vierten Nebengruppe (Titangruppe) des Periodensystems der Elemente.

Die atomaren Vorgänge bei der lichtinduzierten Ausbildung der amphiphilen Eigenschaft des Materials der Druckformoberfläche lassen darauf schließen, daß sich ein für den vorliegenden Anwendungszweck geeignetes Material oder Materialgemisch finden läßt, das nicht nur durch entsprechende Belichtung amphiphil gemacht werden kann, sondern dessen amphiphile Eigenschaft gezielt wieder nach hydrophob und oleophob zurückgebildet werden kann. Im Falle von Titanoxid muß die Aktivierungsschwelle überwunden werden, oberhalb derer die bei UV-Belichtung erzeugten Sauerstoff-Fehlstellen unter Sauerstoffangebot wieder besetzt werden. Um die Aktivierungsschwelle zu überwinden, könnte die Oberfläche der Druckform mit einer weiteren Strahlungsquelle belichtet werden, die beispielsweise genügend intensives IR-Licht aussendet. Übrigens könnte eine flächenmäßige Belichtung der Druckform mit einer solchen Strahlungsquelle z.B. in der Reinigungseinrichtung ausgenutzt werden, um die Druckform vor der Neubebilderung flächig in den nicht amphiphilen Zustand zu versetzen.

Ein Material mit den vorstehend beschriebenen Eigenschaften ermöglicht ein drittes erfindungsgemäßes Verfahren, bei dem die Druckformoberfläche zuerst mit einer UV-Flächenbelichtungseinheit belichtet wird und anschließend mit einer Bebilderungseinheit, die z.B. im Sichtbaren oder Infraroten strahlt, in Bildbereichen bestrahlt wird, um die amphiphile Eigenschaft in den Bildbereichen aufzuheben. An den amphiphilen Stellen, den Nichtbildbereichen, wird Wasser angelagert, und anschließend wird in den Bildbereichen Farbe an der Druckform angelagert. Dieses Verfahren benötigt eine Druckfarbe, die in genügendem Maße an den nicht amphiphilen Stellen haftet. Dies kann gegebenenfalls dadurch erreicht werden, daß die amphiphile Eigenschaft durch geeignete Bestrahlung in den Bildbereichen nicht vollständig, sondern nur bis zu einem gewissen Grade zurückgebildet wird.

Mit der Erfindung kann die Druckfarbe über einen Zwischenträger von der Druckform auf einen Bedruckstoff übertragen werden, z.B. über einen Gummizylinder wie bei konventionellem Offsetdruck. In diesem Fall muß bei einem Wechsel des Druckmotivs nicht nur die Druckform, sondern auch der Zwischenträger gereinigt werden. Die Reinigung eines Zwischenträgers entfällt, wenn die Druckfarbe ähnlich wie im Tiefdruck direkt von der Druckform auf einen Bedruckstoff übertragen wird.

Wie erwähnt, ermöglicht es die Erfindung, sowohl kontinuierlich von einem Master zu drucken, wobei das Motiv von Druck zu Druck gleich bleibt, als auch variabel zu drucken, wobei das Motiv von Druck zu Druck geändert wird, und man kann zu jeder Zeit von einem dieser Verfahren auf das andere wechseln.

Nachstehend wird die Erfindung anhand von Ausführungsbeispielen unter Bezugnahme auf die Zeichnungen näher erläutert. In der Zeichnung zeigen:
- **Fig. 1**: eine Druckmaschine mit einem wiederbeschreibbaren Formzylinder zur Durchführung eines ersten Druckverfahrens,
- **Fig. 2**: eine Druckmaschine mit einem wiederbeschreibbaren Formzylinder zur Durchführung eines zweiten Druckverfahrens,

In allen Figuren sind gleiche oder funktionsgleiche Bestandteile mit gleichen Bezugszeichen bezeichnet.

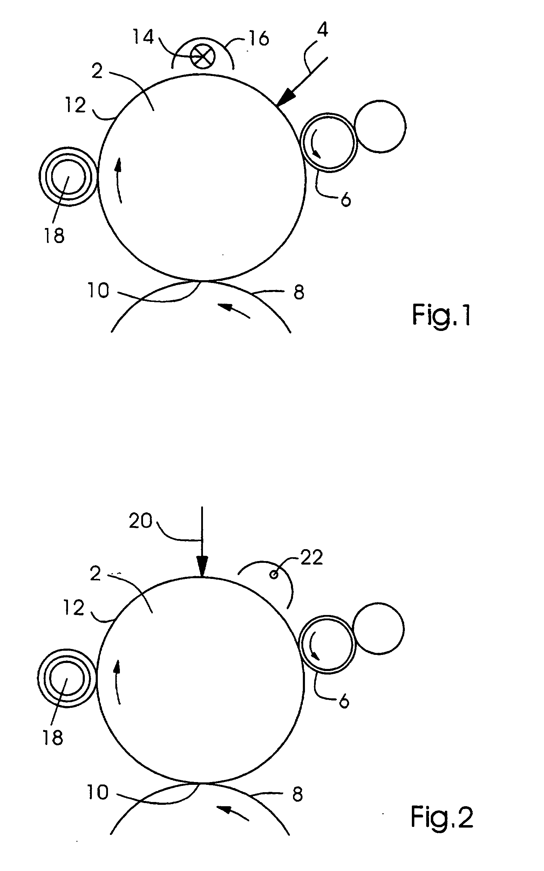

Die in Fig. 1 schematisch gezeigte Druckmaschine enthält einen Formzylinder 2 mit einer Oberfläche 12 aus einem Material, das die Eigenschaft hat, zwei verschiedene Zustände annehmen zu können, einen ersten Zustand, in dem eine an die Oberfläche 12 angrenzende Flüssigkeit einen relativ großen Randwinkel bildet, z.B. 72° für Wasser, und einen zweiten Zustand mit einem sehr kleinen Randwinkel von nahezu 0°. Eine solche Oberfläche 12 ist z.B. eine Keramik aus Titanoxid (TiO₂) oder aus modifiziertem Titanoxid. Der erste Zustand stellt sich mit der Zeit automatisch ein, wenn sich die Oberfläche 12 in einer dunklen und trockenen Umgebung befindet, und ausgehend von diesem Zustand wird der zweite Zustand durch Einwirkung von ultravioletter Strahlung erreicht. In dem zweiten Zustand ist die Oberfläche 12 extrem amphiphil, d.h. sowohl hydrophil als auch oleophil. Wasser oder Öl, das damit in Kontakt kommt, spreitet sich zu einem extrem dünnen Film.

Am Umfang des Formzylinders 2 sind nacheinander eine UV-Flächenbelichtungsstation, eine IR-Bebilderungsstation, ein Farbwerk, eine Übertragungsstation und eine Reinigungsstation angeordnet.

Die IR-Bebilderungsstation enthält eine schematisch dargestellte IR-Bebilderungseinheit 4, die z.B. ein steuerbarer Infrarotlaser mit einer Strahlablenkeinheit oder eine LED-Zeile mit Infrarot-Leuchtdioden ist, um den Formzylinder 2 in Übereinstimmung mit einem Druckbild aus digitalen Datenbeständen bildpunktweise zu belichten.

Das Farbwerk enthält eine Farbwalze 6, die auf der Oberfläche 12 des Formzylinders 2 abrollt und über weitere Walzen und nicht gezeigte Farbversorgungen gleichmäßig mit Druckfarbe versorgt wird, um den Formzylinder 2 in Übereinstimmung mit dem Druckbild einzufärben.

Die Übertragungsstation enthält einen Zylinder 8 in Form eines Gummizylinders oder eines anderen Zwischenträgers, auf den das auf dem Formzylinder 2 gebildete Druckbild aus Druckfarbe an einer linienförmigen Berührungsstelle 10 zwischen dem Formzylinder 2 und dem Zylinder 8 übertragen wird. An einer anderen, nicht gezeigten Stelle am Umfang des Zylinders 8 wird das Druckbild weiter auf einen Bedruckstoff übertragen, z.B. auf eine Weise, wie sie aus dem Offsetdruck bekannt ist. Alternativ kann der Bedruckstoff zwischen dem Formzylinder 2 und dem Zylinder 8 hindurchgeführt werden, d.h. wie z.B. im Tiefdruck direkt bedruckt werden. In diesem Fall stellt der Zylinder 8 einen Gegendruckzylinder dar.

Die Reinigungsstation enthält eine schematisch dargestellte Reinigungseinrichtung 18, die wahlweise aktivierbar ist, um die Oberfläche 12 des Formzylinders 2 von übriggebliebener Druckfarbe zu reinigen.

Die UV-Flächenbelichtungseinheit enthält eine Ultraviolettlampe 14 mit einem Reflektor 16, um die Oberfläche 12 des Formzylinders 2 gleichmäßig mit UV-Licht zu bestrahlen. Der Reflektor 16 kann außerdem einen mehr oder weniger geschlossenen Raum über der Oberfläche 12 des Formzylinders 2 abgrenzen, dem Wasserdampf oder wasserdampfhaltige Luft zugeführt wird, dem bzw. der die Oberfläche 12 des Formzylinders 2 ausgesetzt ist, wenn sie die UV-Flächenbelichtungseinheit passiert.

Die in Fig. 1 gezeigte Druckmaschine arbeitet wie folgt. Der Formzylinder 2, die Farbwalze 6 und der Zylinder 8 drehen sich in den eingezeichneten Pfeilrichtungen. Die von der Ultraviolettlampe 14 mit UV-Licht bestrahlte Oberfläche 12 des Formzylinders 2 wird extrem wasseranziehend. In Gegenwart von Wasser entsteht eine molekulare Wasserschicht, ein sehr dünner gleichmäßiger Wasserfilm, der erheblich dünner als im konventionellen Offsetdruck ist. Bei genügender Luftfeuchtigkeit der Umgebungsluft kann dieser Wasserfilm auf dem Wege der Oberfläche 12 von der Flächenbelichtungseinheit zur IR-Bebilderungseinheit 4 gebildet werden. Andernfalls kann die Bildung der molekularen Wasserschicht durch die erwähnte Zufuhr von Wasserdampf oder wasserdampfhaltiger Luft gefördert werden, z.B. im Bereich der Ultraviolettlampe 14 oder an irgendeiner anderen Stelle auf dem Wege der Oberfläche 12 von der UV-Flächenbelichtungseinheit zur IR-Bebilderungseinheit 4.

Mittels der IR-Bebilderungseinheit 4 wird die molekulare Wasserschicht in den durch die digitalen Daten bestimmten Bildbereichen abgetragen oder vereinfacht ausgedrückt verdampft, so daß die Oberfläche 12 des Formzylinders 2 in diesen Bereichen ausreichend wasserfrei wird. Die IR-Bebilderungseinheit 4 ist möglichst nahe an der Farbwalze 6 angeordnet, damit die Druckfarbe an den Formzylinder 2 angetragen wird, bevor sich Wasser aus der Umgebungsluft daran anlagern kann. Falls notwendig, kann die Baugruppe aus der IR-Bebilderungseinheit 4 und der Farbwalze 6 durch ein gemeinsames Gehäuse, in dem sich trockene Luft unter geringen Überdruck befindet, von der umgebenden Luft abgeschirmt werden.

Da die freigelegten Oberflächenbereiche des Formzylinders 2 farbannehmend sind, die mit einer molekularen Wasserschicht bedeckten Bereiche aber farbabstoßend sind, überträgt die Farbwalze 6 nur in den IR-belichteten Bereichen Farbe auf den Formzylinder 2, auf dem somit ein Druckbild aus Druckfarbe entsteht.

Beim Farbübertrag auf den Zylinder 8 oder direkt z.B. auf Papier spaltet sich die Farbe, wie es aus dem Offsetdruck bekannt ist. Dadurch bleibt Restfarbe bildmäßig auf der Oberfläche 12 des Formzylinders 2 erhalten. Wenn die Oberfläche 12 des Formzylinders 2 die Farbwalze 6 das nächste Mal passiert, wird die Farbe daher ergänzt, ohne daß vorher neu bebildert werden muß. Somit können viele Druckvorgänge schnell aufeinanderfolgend durchgeführt werden. Während dessen kann die UV-Flächenbelichtungseinheit ausgeschaltet bleiben.

Soll das Druckbild geändert werden, so tritt die Reinigungseinrichtung 18 in Aktion, um die Oberfläche 12 des Formzylinders 2 von Restfarbe zu reinigen. Die gereinigte Oberfläche 12 wird durch das Licht von der Ultraviolettlampe 14 wieder vollständig amphiphil gemacht. Nach der Aufnahme einer zusammenhängenden molekularen Wasserschicht wird die Oberfläche 12 von der IR-Bebilderungseinheit 4 in Übereinstimmung mit dem nächsten Druckbild freigelegt und entsprechend eingefärbt, so daß der nächste kontinuierliche Druck durchgeführt werden kann.

Die in Fig. 2 gezeigte Druckmaschine gleicht derjenigen von Fig. 1 mit den Änderungen, daß die Ultraviolettlampe 14 entfällt und daß die IR-Bebilderungseinheit 4 durch eine UV-Bebilderungseinheit 20 ersetzt ist, welche die gleichen Funktionen wie die IR-Bebilderungseinheit 4 von Fig. 1 durchführt, jedoch mit ultraviolettem statt mit infrarotem Licht arbeitet.

Um mit der in Fig. 2 gezeigten Druckmaschine zu drucken, wird der Formzylinder 2 bildmäßig negativ (d.h. in Nichtbildbereichen) UV-belichtet. An den belichteten Stellen lagert sich Wasser an, das aus der Umgebungsluft stammt oder das dem Formzylinder 2 an einer Feuchtluftstation 22 zugeführt wird. Die unbelichteten Stellen werden von der Farbwalze 6 eingefärbt. Im weiteren Verlauf erfolgt der Druck so wie im Zusammenhang mit Fig. 1 beschrieben.

Bei einem Wechsel des Druckbildes wird die Restfarbe mittels der Reinigungseinrichtung 18 von der Oberfläche 12 des Formzylinders 2 entfernt. Falls nicht abgewartet werden kann, daß sich der Zustand der Oberfläche 12 mit einem relativ großem Randwinkel von selbst wieder einstellt, kann die Reinigungseinrichtung 18 zusätzlich auf eine solche Weise chemisch und/oder physikalisch auf die Oberfläche 12 einwirken, daß die Rückkehr in den Ursprungszustand beschleunigt wird. Alternativ kann von vornherein für eine kurze Standzeit der amphiphilen Eigenschaft der Oberfläche 12 des Formzylinders 2 gesorgt werden, z.B. 0,1 bis 1 Sekunde, bei der sich die amphiphile Eigenschaft gerade während eines Umlaufs des Formzylinders 2 von selbst verliert, so daß er unmittelbar neu beschrieben werden kann. In jedem Fall muß die Oberfläche 12 des Formzylinders 2 völlig trocken sein, bevor sie neu beschrieben werden kann.

In einem weiteren, in den Figuren nicht dargestellten Ausführungsbeispiel sind am Umfang des Formzylinders eine UV-Flächenbelichtungseinheit und eine Bebilderungseinheit für Licht mit einer größeren Wellenlänge als UV-Licht angeordnet. Der Formzylinder wird mit der UV-Flächenbelichtungseinheit flächig amphiphil gemacht, und das Oberflächenmaterial des Formzylinders ist so gewählt, daß die Bebilderungseinheit die amphiphile Eigenschaft in den Bildbereichen zumindest teilweise wieder aufheben kann. An den amphiphilen Stellen entstehen in Gegenwart von Wasser kleine Wasserinseln molekularer Dicke, die beim anschließenden Farbauftrag keine Farbe annehmen, während in den Bildbereichen genügend Farbe für den nachfolgenden Farbübertrag auf Papier oder einen Zwischenträger angelagert wird.

### Druckmaschine mit Druckverfahren

### Bezugszeichenliste

- 2: Formzylinder
- 4: IR-Bebilderungseinheit
- 6: Farbwalze
- 8: Zylinder
- 10: Berührungsstelle
- 12: Oberfläche
- 14: Ultraviolettlampe
- 16: Reflektor
- 18: Reinigungseinrichtung
- 20: UV-Bebilderungseinheit
- 22: Feuchtluftstation
- 24: Feuchtwalze

## Patentansprüche

1. Druckverfahren mit den aufeinanderfolgenden Verfahrensschritten,
a) eine Druckform (2), deren Oberfläche (12) aus einem Material besteht, dessen Benetzungseigenschaften reversibel zwischen einem Zustand mit einem sehr kleinen Randwinkel und einem Zustand mit einem relativ großen Randwinkel veränderlich sind, flächig mit Licht zu belichten, dessen Wellenlänge kürzer als eine materialspezifische Wellenlänge ist, um sie in den Zustand mit einem sehr kleinen Randwinkel zu bringen,
d) die Druckform einzufärben, wobei die Druckfarbe in den Bildbereichen von der Druckform angenommen wird,
e) die Druckfarbe von der Druckform auf einen Bedruckstoff zu übertragen,
f) die Verfahrensschritte d) und e) nach Bedarf zu wiederholen und
g) die Druckform zu reinigen,
**gekennzeichnet durch** die Verfahrensschritte:
b) eine molekulare Wasserschicht auf der Druckform zu bilden,
c) Bildbereiche der Druckform mit Licht zu bestrahlen, das eine größere Wellenlänge als die materialspezifische Wellenlänge hat, um **dadurch** die molekulare Wasserschicht auf der Druckform in den Bildbereichen zu entfernen,
wobei die Verfahrensschritte b) und c) auf Verfahrensschritt a) folgen.

2. Verfahren nach Anspruch 1,
**dadurch gekennzeichnet,**
**dass** die molekulare Wasserschicht aus in der Umgebungsluft enthaltenem Wasser gebildet wird.

3. Verfahren nach Anspruch 1,
**dadurch gekennzeichnet,**
**dass** die molekulare Wasserschicht aus in zugeführtem Wasserdampf oder zugeführter wasserdampfhaltiger oder feuchter Luft enthaltenem Wasser gebildet wird.

4. Verfahren nach einem der Ansprüche 1 bis 3,
**dadurch gekennzeichnet,**
**dass** der Verfahrensschritt e) unter Ausschluss von vorherigem Feuchtmittelauftrag auf die Druckform durchgeführt wird.

5. Druckverfahren mit den aufeinanderfolgenden Verfahrensschritten,
a) eine Druckform (2), deren Oberfläche (12) aus einem Material besteht, dessen Benetzungseigenschaften reversibel zwischen einem Zustand mit einem sehr kleinen Randwinkel und einem Zustand mit einem relativ großen Randwinkel veränderlich sind, flächig mit Licht zu belichten, dessen Wellenlänge kürzer als eine materialspezifische Wellenlänge ist, um sie in den Zustand mit einem sehr kleinen Randwinkel zu bringen,
b) Bildbereiche der Druckform mit Licht zu bestrahlen, das eine größere Wellenlänge als die materialspezifische Wellenlänge hat, um die Bildbereiche in den Zustand mit einem relativ großen Randwinkel zu bringen,
d) die Druckform einzufärben, wobei die Druckfarbe in den Bildbereichen von der Druckform angenommen wird,
e) die Druckfarbe von der Druckform auf einen Bedruckstoff zu übertragen,
f) die Verfahrensschritte d) und e) nach Bedarf zu wiederholen und
g) die Druckform zu reinigen,
**gekennzeichnet durch** den Verfahrensschritt:
c) in den Nichtbildbereichen der Druckform eine molekulare Wasserschicht auf der Druckform zu bilden,
wobei Verfahrensschritt c) auf Verfahrensschritt b) folgt.

6. Verfahren nach Anspruch 5,
**dadurch gekennzeichnet,**
**dass** die molekulare Wasserschicht in Gegenwart von Wasser gebildet wird.

7. Druckverfahren mit den aufeinanderfolgenden Verfahrensschritten,
a) eine Druckform (2), deren Oberfläche (12) aus einem Material besteht, dessen Benetzungseigenschaften reversibel zwischen einem Zustand mit einem sehr kleinen Randwinkel und einem Zustand mit einem relativ großen Randwinkel veränderlich sind, in Nichtbildbereichen mit Licht zu belichten, dessen Wellenlänge kürzer als eine materialspezifische Wellenlänge ist, um die Nichtbildbereiche in den Zustand mit einem sehr kleinen Randwinkel zu bringen,
c) die Druckform einzufärben, wobei die Druckfarbe in den Bildbereichen von der Druckform angenommen wird,
d) die Druckfarbe von der Druckform auf einen Bedruckstoff zu übertragen,
e) die Verfahrensschritte c) und d) nach Bedarf zu wiederholen und
f) die Druckform zu reinigen,
**gekennzeichnet durch** den Verfahrensschritt:
b) eine molekulare Wasserschicht auf den Nichtbildbereichen zu bilden
wobei Verfahrensschritt b) auf Verfahrensschritt a) folgt.

8. Verfahren nach Anspruch 7,
**dadurch gekenntzeichnet,**
dass die molekulare Wasserschicht aus in der Umgebungsluft enthaltenem Wasser gebildet wird.

9. Verfahren nach Anspruch 7,
**dadurch gekennzeichnet,**
**dass** die molekulare Wasserschicht aus von einer Feuchtluftstation zugeführtem Wasser gebildet wird.

10. Verfahren nach einem der Ansprüche 7 bis 9,
**dadurch gekennzeichnet,**
**dass** der Verfahrensschritt d) unter Ausschluss von vorherigem Feuchtmittelauftrag auf die Druckform durchgeführt wird.

11. Verfahren nach einem der vorhergehenden Ansprüche,
**dadurch gekennzeichnet,**
**dass** die molekulare Wasserschicht eine molekulare Dicke, insbesondere eine Dicke zwischen einer und mehreren Moleküllagen aufweist.

12. Verfahren nach einem der vorhergehenden Ansprüche
**dadurch gekennzeichnet,**
**daß** die Druckfarbe unmittelbar von der Druckform (2) auf einen Bedruckstoff übertragen wird.

13. Verfahren nach einem der Ansprüche 1 bis 11
**dadurch gekennzeichnet,**
**daß** die Druckfarbe über einen Zwischenträger (8) von der Druckform (2) auf einen Bedruckstoff übertragen wird.

14. Verfahren nach einem der vorhergehenden Ansprüche
**dadurch gekennzeichnet,**
**daß** nach Wahl entweder kontinuierlich mit einem von Druck zu Druck gleichen Motiv oder variabel mit einem von Druck zu Druck verschiedenen Motiv gedruckt wird.

15. Druckmaschine mit einer Druckform, einer optischen Bebilderungseinheit zur Direktbebilderung der Druckform, einem Farbwerk zur Einfärbung der Druckform und einer Reinigungseinrichtung (18) zur Reinigung der Oberfläche der Druckform, wobei die Oberfläche (12) der Druckform (2) aus einem Material besteht, dessen Benetzungseigenschaften reversibel zwischen einem Zustand mit einem sehr kleinen Randwinkel und einem Zustand mit einem relativ großen Randwinkel veränderlich sind, und wobei der Zustand mit einem sehr kleinen Randwinkel durch Einwirkung von Licht erreicht wird, dessen Wellenlänge kürzer als eine materialspezifische Wellenlänge ist,
**dadurch gekennzeichnet,**
**dass** eine Feuchtluftstation (14,16,22) zur Bildung einer molekularen Wasserschicht auf der Druckform vorgesehen ist.

16. Druckmaschine nach Anspruch 15,
**dadurch gekennzeichnet,**
**dass** eine Flächenbelichtungseinheit (14, 16) zur gleichmäßigen Belichtung der Druckform mit Licht, dessen Wellenlänge kürzer als die materialspezifische Wellenlänge ist, vorgesehen ist.

17. Druckmaschine nach Anspruch 16,
**dadurch gekennzeichnet,**
**dass** die Flächenbelichtungseinheit (14, 16) als Ultraviolett-Flächenbelichtungseinheit ausgebildet ist.

18. Druckmaschine nach einem der Ansprüche 15-17,
**dadurch gekennzeichnet,**
**daß** die optische Bebilderungseinheit (4) mittels Licht einer größeren Wellenlänge als der materialspezifischen Wellenlänge sowie entsprechender Intensität und Einwirkungsdauer die molekulare Wasserschicht auf der Druckform (2) in Bildbereichen entfernt.

19. Druckmaschine nach Anspruch 15,
**dadurch gekennzeichnet,**
**daß** die optische Bebilderungseinheit (20) Licht aussendet, dessen Wellenlänge kürzer als die materialspezifische Wellenlänge ist.

20. Druckmaschine nach Anspruch 19,
**dadurch gekennzeichnet,**
**daß** das von der optischen Bebilderungseinheit (20) ausgesandte Licht ein Negativbild des Druckbildes darstellt.

21. Druckmaschine nach einem der Ansprüche 15 bis 20,
**dadurch gekennzeichnet,**
**daß** das Material der Oberfläche (12) der Druckform (2) TiO₂ enthält.

22. Druckmaschine nach einem der Ansprüche 15 bis 21,
**dadurch gekennzeichnet,**
**daß** die Druckform ein Formzylinder (2), eine Platte oder ein Band ist.

## Claims

1. Printing method having the successive method steps of
a) exposing a printing form (2) with a surface (12) formed of a material that has wetting properties reversibly changeable between a state with a very small contact angle and a state with a relatively large contact angle over its entire area to light that has a wavelength shorter than a material-specific wavelength to bring the printing form into the state with the very small contact angle;
d) inking the printing form so that printing ink is accepted by the printing form in the image areas;
e) transferring the printing ink from the printing form to printing stock;
f) repeating the method steps d) and e) as required; and
g) cleaning the printing form,
**characterized by**
the method steps:
b) forming a molecular water layer on the printing form;
c) irradiating image areas of the printing form with a light with a wavelength that is greater than the material-specific wavelength in order to remove the molecular water layer on the printing form in the image areas,
with method steps b) and c) succeeding method step a).

2. Method according to claim 1,
**characterized in**
**that** the molecular water layer is formed of water present in the ambient air.

3. Method according to claim 1,
**characterized in**
**that** the molecular water layer is formed of water present in water vapour or moist air or air containing water vapour that is supplied.

4. Method according to one of claims 1 to 3,
**characterized in**
**that** the method step e) is performed excluding any prior application of dampening solution to the printing form.

5. Printing method having the successive method steps of
a) exposing a printing form (2) with a surface (12) formed of a material that has wetting properties reversibly changeable between a state with a very small contact angle and a state with a relatively large contact angle over its entire area to light that has a wavelength shorter than a material-specific wavelength to bring the printing form into the state with the very small contact angle;
b) irradiating image areas of the of the printing form with a light that has a wavelength greater than the material-specific wavelength in order to bring the image areas into the state with a relatively large contact angle;
d) inking the printing form so that printing ink is accepted by the printing form in the image areas;
e) transferring the printing ink from the printing form to printing stock;
f) repeating the method steps d) and e) as required; and
g) cleaning the printing form,
**characterized by**
the method step of
c) forming a molecular water layer on the printing form in the non-image areas of the printing form,
with method step c) succeeding method step b).

6. Method according to claim 5,
**characterized in**
**that** the molecular water layer is formed in the presence of water.

7. Printing method having the successive method steps of
a) exposing a printing form (2) with a surface (12) formed of a material that has wetting properties reversibly changeable between a state with a very small contact angle and a state with a relatively large contact angle over its entire area to light that has a wavelength shorter than a material-specific wavelength to bring the printing form into the state with the very small contact angle;
c) inking the printing form so that printing ink is accepted by the printing form in the image areas;
d) transferring the printing ink from the printing form to printing stock;
e) repeating the method steps c) and d) as required; and
f) cleaning the printing form,
**characterized by** the method step of
b) forming a molecular water layer on the non-image areas of the printing form,
with method step b) succeeding method step a).

8. Method according to claim 7,
**characterized in**
**that** the molecular water layer is formed of water present in the ambient air.

9. Method according to claim 7,
**characterized in**
**that** the molecular water layer is formed of water supplied by a moist air station.

10. Method according to one of claims 7 to 9,
**characterized in**
**that** method step d) is performed excluding any prior application of dampening solution to the printing form.

11. Method according to one of the preceding claims,
**characterized in**
**that** the molecular water layer has a molecular thickness, in particular a thickness between one or more molecular layers.

12. Method according to one of the preceding claims,
**characterized in**
**that** the printing ink is directly transferred from the printing form (2) to printing stock.

13. Method according to one of claims 1 to 11,
**characterized in**
**that** the printing ink is transferred from the printing form (2) to printing stock via an intermediate carrier (8).

14. Method according to one of the preceding claims,
**characterized in**
**that** printing selectively occurs continuously with the same motif from print to print or variably with a different motif from print to print.

15. Printing machine comprising a printing form, an optical imaging unit for directly imaging the printing form, an inking unit for inking the printing form, and a cleaning device (18) for cleaning the surface of the printing form, the surface (12) of the printing form (2) being formed of a material that has wetting properties reversibly changeable between a state having a very small contact angle and a state having a relatively large contact angle, the state with the very small contact angle being achieved by the action of light having a wavelength that is shorter than a material-specific wavelength,
**characterized in**
**that** a moist air station (14, 16, 22) is provided for forming a molecular water layer on the printing form.

16. Printing machine according to claim 15,
**characterized in**
**that** an area exposure unit (14, 16) is provided for uniformly exposing the printing form with a light that has a wavelength shorter than the material-specific wavelength.

17. Printing machine according to claim 16,
**characterized in**
**that** the area exposure unit (14, 16) is an ultraviolet area exposure unit.

18. Printing machine according to one of claims 15 to 17,
**characterized in**
**that** the optical imaging unit (4) removes the molecular water layer on the printing form (2) in image areas by using light that has a wavelength greater than the material-specific wavelength and an appropriate intensity and period of action.

19. Printing machine according to claim 15,
**characterized in**
**that** the optical imaging unit (20) emits a light that has a wavelength shorter than the material-specific wavelength.

20. Printing machine according to claim 19,
**characterized in**
**that** the light emitted from the optical imaging unit (20) represents a negative image of the printing image.

21. Printing machine according to one of claims 15 to 20,
**characterized in**
**that** the material of the surface (12) of the printing form (2) contains TiO₂.

22. Printing machine according to one of claims 15 to 21,
**characterized in**
**that** the printing form is a form cylinder (2), a plate, or a belt.

## Revendications

1. Procédé d'impression comprenant les étapes de procédé successives suivantes, à savoir
a) l'irradiation de surface d'une forme d'impression (2) dont la surface (12) est constituée d'un matériau dont les propriétés de mouillage sont variables de manière réversible entre un état à angle de mouillage très petit et un état à angle de mouillage relativement grand, avec de la lumière dont la longueur d'onde est plus courte qu'une longueur d'onde spécifique au matériau, en vue d'amener ladite forme d'impression dans l'état à angle de mouillage très petit,
d) l'encrage de la forme d'impression, l'encre d'impression étant acceptée dans les zones d'image de la forme d'impression,
e) le transfert de l'encre d'impression de la forme d'impression sur un support d'impression,
f) la répétition des étapes de procédé d) et e) suivant les besoins, et
g) le nettoyage de la forme d'impression,
**caractérisé par** les étapes de procédé suivantes, à savoir :
b) la formation d'une couche d'eau moléculaire sur la forme d'impression,
c) l'irradiation de zones d'image de la forme d'impression avec de la lumière qui présente une longueur d'onde plus grande que la longueur d'onde spécifique au matériau, en vue d'éliminer ainsi la couche d'eau moléculaire sur la forme d'impression dans les zones d'image,
les étapes de procédé b) et c) succédant à l'étape de procédé a).

2. Procédé selon la revendication 1, **caractérisé en ce que** la couche d'eau moléculaire est formée à partir d'eau contenue dans l'air environnant.

3. Procédé selon la revendication 1, **caractérisé en ce que** la couche d'eau moléculaire est formée à partir d'eau contenue dans de la vapeur d'eau amenée ou dans de l'air amené qui est humide ou contient de la vapeur d'eau.

4. Procédé selon l'une des revendications 1 à 3, **caractérisé en ce que** l'étape de procédé e) est effectuée sans application préalable d'agent de mouillage sur la forme d'impression.

5. Procédé d'impression comprenant les étapes de procédé successives suivantes, à savoir
a) l'irradiation de surface d'une forme d'impression (2) dont la surface (12) est constituée d'un matériau dont les propriétés de mouillage sont variables de manière réversible entre un état à angle de mouillage très petit et un état à angle de mouillage relativement grand, avec de la lumière dont la longueur d'onde est plus courte qu'une longueur d'onde spécifique au matériau, en vue d'amener ladite forme d'impression dans l'état à angle de mouillage très petit,
b) l'irradiation de zones d'image de la forme d'impression avec de la lumière qui présente une longueur d'onde plus grande que la longueur d'onde spécifique au matériau, en vue d'amener les zones d'image dans l'état à angle de mouillage relativement grand,
d) l'encrage de la forme d'impression, l'encre d'impression étant acceptée dans les zones d'image de la forme d'impression,
e) le transfert de l'encre d'impression de la forme d'impression sur un support d'impression,
f) la répétition des étapes de procédé d) et e) suivant les besoins, et
g) le nettoyage de la forme d'impression,
**caractérisé par** l'étape de procédé suivante, à savoir :
c) la formation d'une couche d'eau moléculaire dans les zones de non image sur la forme d'impression,
l'étape de procédé c) succédant à l'étape de procédé b).

6. Procédé selon la revendication 5, **caractérisé en ce que** la couche d'eau moléculaire est formée en présence d'eau.

7. Procédé d'impression comprenant les étapes de procédé successives suivantes, à savoir
a) l'irradiation des zones de non image d'une forme d'impression (2) dont la surface (12) est constituée d'un matériau dont les propriétés de mouillage sont variables de manière réversible entre un état à angle de mouillage très petit et un état à angle de mouillage relativement grand, avec de la lumière dont la longueur d'onde est plus courte qu'une longueur d'onde spécifique au matériau, en vue d'amener les zones de non image dans l'état à angle de mouillage très petit,
c) l'encrage de la forme d'impression, l'encre d'impression étant acceptée dans les zones d'image de la forme d'impression,
d) le transfert de l'encre d'impression de la forme d'impression sur un support d'impression,
e) la répétition des étapes de procédé c) et d) suivant les besoins, et
f) le nettoyage de la forme d'impression,
**caractérisé par** l'étape de procédé suivante, à savoir :
b) la formation d'une couche d'eau moléculaire sur les zones de non image,
l'étape de procédé b) succédant à l'étape de procédé a).

8. Procédé selon la revendication 7, **caractérisé en ce que** la couche d'eau moléculaire est formée à partir d'eau contenue dans l'air environnant.

9. Procédé selon la revendication 7, **caractérisé en ce que** la couche d'eau moléculaire est formée à partir d'eau amenée d'un poste d'air humide.

10. Procédé selon l'une des revendications 7 à 9, **caractérisé en ce que** l'étape de procédé d) est effectuée sans application préalable d'agent de mouillage sur la forme d'impression.

11. Procédé selon l'une des revendications précédentes, **caractérisé en ce que** la couche d'eau moléculaire présente une épaisseur moléculaire, notamment une épaisseur entre une et plusieurs couches de molécules.

12. Procédé selon l'une des revendications précédentes, **caractérisé en ce que** l'encre d'impression est transférée directement de la forme d'impression (2) sur un support d'impression.

13. Procédé selon l'une des revendications 1 à 11, **caractérisé en ce que** l'encre d'impression est transférée à l'aide d'un support intermédiaire (8), de la forme d'impression (2) sur un support d'impression.

14. Procédé selon l'une des revendications précédentes, **caractérisé en ce que** l'impression se fait au choix, soit de manière continue avec un motif restant le même d'impression en impression, soit de manière variable avec un motif différent d'impression en impression.

15. Machine à imprimer comprenant une forme d'impression, une unité optique de formation d'image pour la formation directe d'image sur la forme d'impression, un groupe d'encrage pour encrer la forme d'impression, et un dispositif de nettoyage (18) pour nettoyer la surface de la forme d'impression, la surface (12) de la forme d'impression (2) étant réalisée en un matériau dont les propriétés de mouillage sont variables de manière réversible entre un état à angle de mouillage très petit et un état à angle de mouillage relativement grand, et l'état à angle de mouillage très petit étant atteint par l'action de lumière dont la longueur d'onde est plus courte qu'une longueur d'onde spécifique au matériau,
**caractérisée en ce qu'**il est prévu un poste d'air humide (14, 16, 22) pour former une couche d'eau moléculaire sur la forme d'impression.

16. Machine à imprimer selon la revendication 15, **caractérisée en ce qu'**il est prévu une unité d'irradiation de surface (14, 16) pour irradier de manière uniforme la forme d'impression, avec de la lumière dont la longueur d'onde est plus courte que la longueur d'onde spécifique au matériau.

17. Machine à imprimer selon la revendication 16, **caractérisée en ce que** l'unité d'irradiation de surface (14, 16) est réalisée en tant qu'unité d'irradiation aux ultraviolets.

18. Machine à imprimer selon l'une des revendications 15-17, **caractérisée en ce que** l'unité optique de formation d'image (4) élimine la couche d'eau moléculaire sur la forme d'impression (2), dans les zones d'image, au moyen de lumière d'une longueur d'onde plus grande que la longueur d'onde spécifique au matériau et avec une intensité et une durée d'action appropriées.

19. Machine à imprimer selon la revendication 15, **caractérisée en ce que** l'unité optique de formation d'image (20) émet de la lumière dont la longueur d'onde est plus courte que la longueur d'onde spécifique au matériau.

20. Machine à imprimer selon la revendication 19, **caractérisée en ce que** la lumière émise par l'unité optique de formation d'image (20), représente une image négative de l'image d'impression.

21. Machine à imprimer selon l'une des revendications 15 à 20, **caractérisée en ce que** le matériau de la surface (12) de la forme d'impression (2) renferme TiO₂.

22. Machine à imprimer selon l'une des revendications 15 à 21, **caractérisée en ce que** la forme d'impression est un cylindre de forme d'impression (2), une plaque ou une bande.
